Europäisches Patentamt

European Patent Office

Office européen des brevets

(11) Publication number: **0 371 700 B1**

(19)

(12) # EUROPEAN PATENT SPECIFICATION

(45) Date of publication of patent specification: 30.03.94 (51) Int. Cl.5: **H04L 27/38**, H04B 7/26, H03G 3/20, H04B 7/005

(21) Application number: 89312183.0

(22) Date of filing: 23.11.89

(54) **Digital automatic gain control.**

(30) Priority: 30.11.88 US 278051

(43) Date of publication of application:
06.06.90 Bulletin 90/23

(45) Publication of the grant of the patent:
30.03.94 Bulletin 94/13

(84) Designated Contracting States:
AT BE CH DE ES FR GB GR IT LI LU NL SE

(56) References cited:
EP-A- 0 086 514
EP-A- 0 238 286
WO-A-86/00486
DE-A- 3 540 722

IBM TECHNICAL DISCLOSURE BULLETIN, vol.
19, no. 3, August 1976, pages 1005-1006, New
York, US; M.L. SHULMAN et al.: "Power level
control in TDMA satellite communication
system"

NTC '77 CONFERENCE RECORD, 1977, vol. 3,
pages 43:2-1 - 43:2-3, IEEE, New York, US;
D.J. SCHAEFER: "A technique for TDMA
burst power measurement"

(73) Proprietor: **MOTOROLA, INC.**
**1303 East Algonquin Road**
**Schaumburg, IL 60196(US)**

(72) Inventor: **Kepler, James Frank Michael**
**3840 Dauphine**
**Northbrook Illinois 60062(US)**
Inventor: **Borth, David Edward**
**825 S. Harvard Drive**
**Palatine Illinois 60067(US)**
Inventor: **Cerny, Frank Joseph,Jr.**
**8922 West 24th Street**
**North Riverside, Illinois 60546(US)**

(74) Representative: **Dunlop, Hugh Christopher et**
**al**
**Motorola**
**European Intellectual Property Operations**
**Jays Close**
**Viables Industrial Estate**
**Basingstoke, Hampshire RG22 4PD (GB)**

## Description

### The Field of Invention

This invention is concerned with digital automatic gain control. More particularly, this invention is concerned with Automatic Gain Control (AGC) for discontinuous signals in a receiver having limited dynamic range.

### Background of the Invention

Although the concept of Automatic Gain Control (AGC) in radio signal reception is well understood, automatic gain control of Time Division multiplexed Multiple Access (TDMA) signals presents new challenges to the land-mobile industry.

In wideband TDMA systems, such as the cellular system proposed for use in Europe, an RF channel is shared (time-division-multiplexed) among numerous subscribers attempting to access the radio system in certain ones of various time-division-multiplexed time slots. The time slots are arranged into periodically repeating frames. Thus, a radio communication of interest may be periodically discontinuous --interleaved with unrelated signals transmitted in other time slots. The unrelated signals (of widely varying strength) must not influence the gain control of the signals of interest. A formidable challenge then is to provide Automatic Gain Control of these periodically discontinuous TDMA signals.

The challenge is further enhanced by attempting to provide digital AGC in inexpensive receivers -- those having limited dynamic range. Since these signals may vary by as much as 100dB in the land-mobile environment, but modest 8-bit Analog-to-Digital converters (A/D) for digital signal processing are limited to 48dB dynamic range, techniques must be developed for controlling the gain of the signal to keep it within the limited dynamic range of the receiver. The challenge then is to handle a 100dB discontinuous signal with a 48dB device; otherwise, prohibitively expensive A/Ds with greater dynamic range must be utilized.

Another challenge for gain control is introduced by the digital nature of these TDMA transmission systems. Gaussian Minimum Shift Keying (GMSK) modulates the quadrature phases of the signal such that the power of the received signal is more difficult to measure, and neither of the quadrature phases, taken alone, is proportional to the received signal power.

An example of a receiver having AGC is found in EP-A-0238286.

This invention takes as its object to overcome at least some of these challenges and realize certain advantages, presented below.

### Summary of the Invention

In accordance with one embodiment of the invention, there is provided a method of digital Automatic Gain Control (AGC) in a receiver having limited dynamic range, for example, for discontinuous signals. The method is characterized by detecting the level of a received and AGC'd discontinuous signal, comparing the level of the AGC'd signal relative to the dynamic range of the receiver, adjusting the AGC by either progressive attenuation or progressive amplification until the signal falls within the dynamic range of the receiver and further adjusting the AGC to establish a desired relationship between the AGC'd signal and the dynamic range limitation.

There is also provided a method of handoff in a cellular-type transmission system utilizing this method of AGC control.

There is also provided a receiver having AGC according to claim 13.

The method for Automatic Gain Control may be further characterized by digitizing a received and AGC'd discontinuous signal and converting the digitized samples to a power sample to sense the power of and detect the level of the signal.

The method preferably comprises finely-adjusting the AGC of the received signal until optimum use of the full (albeit limited) dynamic range of the signal processing stages is about 6-12 dB below the maximum to establish a desired relationship between the AGC'd signal and the dynamic range limitation.

### Brief Description of the Drawings

Additional objects, features, and advantages of the invention will be more clearly understood and the best mode contemplated for practicing it in its preferred embodiment will be appreciated (by way of unrestricted example) from the following detailed description, taken together with the accompanying drawings in which:

Figure 1 is a simplified block diagram of the invention.

Figure 2 is a functional block diagram of the preferred embodiment of the invention.

Figure 3 is a diagram of the AGC control process according to the invention.

Figure 4 is a simplified diagram of an alternate embodiment of the invention.

### Detailed Description

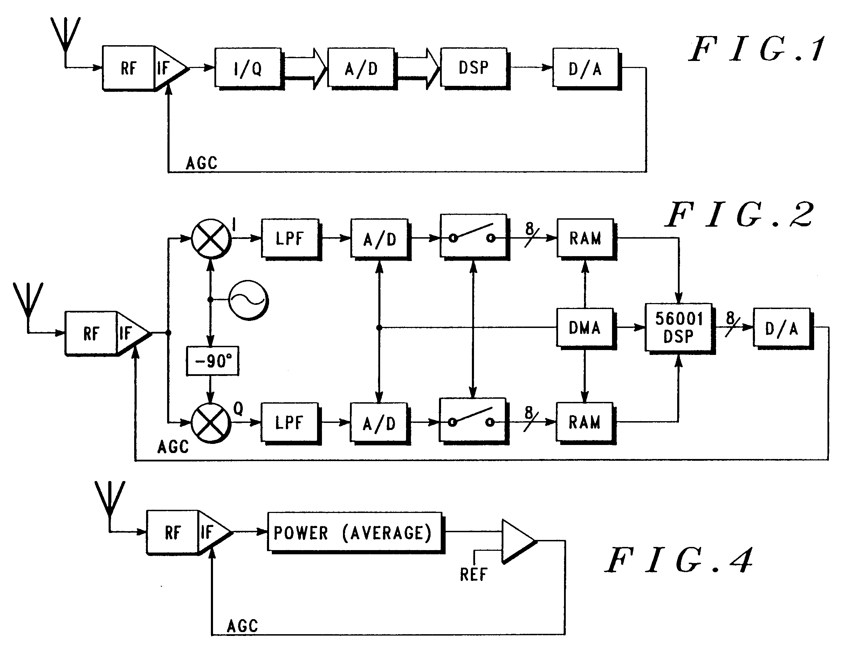

Figure 1 is a simplified block diagram of the invention; it illustrates gain control in a digital quadrature receiver. It illustrates, in series, an RF receiver section (IF), a quadrature demodulator (I/Q) having In-phase and Quadrature phases, Analog-to-Digital converters (A/D), a Digital Signal Processor (DSP), and a Digital-to-Analog converter (D/A) providing Automatic Gain Control (AGC) to the receiver section (RF/IF).

In operation, the signal is received, converted to an intermediate frequency and gain amplified in the receiver section (RF/IF); quadrature demodulated (I/Q) into In-phase and Quadrature components; digitized in Analog-to-Digital converters of limited dynamic range (A/D); and converted to a power sample in the Digital Signal Processors (DSP) to detect the level of the signal. In the Digital Signal Processors (DSP), the signal level is compared relative to the dynamic range of the receiver, and the AGC is adjusted in the Digital-to-Analog converter (D/A) to establish a desired relationship between the AGC'd signal and the dynamic range limitation of the receiver.

More concretely, the power level of the AGC'd signal is compared relative to a desired power level in the stage having the dynamic range limitation.

Figure 2 is a functional block diagram of the preferred embodiment of the invention. Figure 2 illustrates, in line, an RF receiver section (RF/IF); a quadrature demodulator (I/Q) having In-phase (I) and Quadrature (Q) phase mixers whose outputs are Low Pass Filtered (LPF); and, under Direct Memory Access control (DMA), 8-bit Analog-to-Digital converters (A/D), tri-state gates, Random Access Memories (RAM), and a 56001 Digital Signal Processor (56001 DSP); and a latching Digital-to-Analog converter (D/A) providing Automatic Gain Control (AGC) to the receiver section (RF/IF). This GMSK receiver is comprised of a conventional RF stage, mixing and filtering that feeds a 10.7 MHz IF signal to a conventional AGC-type IF amplifier (IF), such as a Motorola MC1350. The IF amplifier feeds a conventional I/Q demodulator comprised of a 10.7 MHz local oscillator, a 90 degree phase shifter, a pair of mixers and a pair of low pass filters (LPF). The 8-bit flash A/Ds, such as RCA CA3318CE's, provide 48dB of dynamic range and are, in large part, responsible for the dynamic range limitation of the receiver. A Motorola 56001 Digital Signal Processor (56001 DSP) is used for signal acquisition, signal level detection, and AGC control. The 56001 DSP is supported by conventional clock and timing circuitry (not shown) and ROMs for programmed control (not shown). An Analog Devices 7528LN is suitable as the latching Digital-to-Analog converter (D/A) that provides Automatic Gain Control (AGC) to the receiver section (IF).

The receiver operates in a TDMA system having 8 time slots in each 4.8 millisecond frame; 135 kilobits/second are transmitted in each quadrature phase. In operation, for each time slot, a retained previous AGC setting is fetched (DMA) from memory (RAM) through the Digital Signal Processor (56001 DSP) and applied to the Digital-to-Analog converter (D/A), providing Automatic Gain Control (AGC) to the receiver section (RF/IF). The received signal, after being gain-controlled and quadrature-demodulated is digitized by the Analog-to-Digital converters (A/D) to provide multiple pairs of samples per bit interval, which are stored in memory (RAM) under Direct Memory Access control (DMA) of the tri-state gates. The samples are retrieved from memory (RAM) and converted in the 56001 DSP to a power sample by summing N pairs (32 to 128 pairs in the preferred embodiment) to obtain a Q value and an I value, and taking the square root of the sum of the squares of the Q and I values. The square root is proportional to the average power of the received signal (an instantaneous power sample from a single pair cannot be reliably obtained due to the variability in the received signal strength). A preferred alternative measure for the power sample may be obtained by simply summing the squares of the Q and I values.

Again, more concretely, the power level of the AGC'd signal is compared relative to a desired power level in the stage having the dynamic range limitation. Thus, to prevent short-term saturation of the 8-bit Analog-to-Digital converters (A/D), the AGC wants to establish and maintain the level of the AGC'd signal at a nominal level of about 6-12dB (9dB in the preferred embodiment) below the maximum output of the A/D.

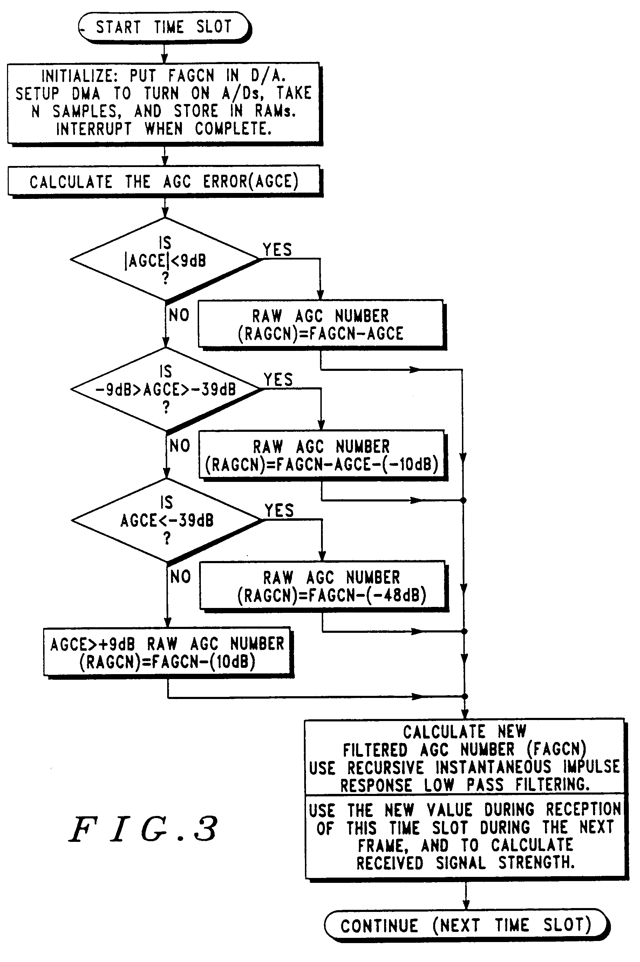

Figure 3 is a diagram of the AGC control process according to the invention.

The basic control process is to:

detect the level of a received and AGC'd discontinuous signal,

compare the level of the AGC'd signal relative to the dynamic range of the receiver, and

adjust the AGC to establish a desired relationship between the AGC'd signal and the dynamic range limitation.

The average power, as measured above, is then subtracted from a power level representative of the desired nominal level (or 9dB, hereinafter given as 0db reference) to calculate the power error. This calculated power error is further factored by an adjustment that compensates for the overall loop gain characteristics, resulting in an AGC Error (AGCE). If the AGC Error (AGCE) is within the margin below full output (9dB), then the prevailing AGC setting (Filtered AGC Number - FAGCN) is finely-adjusted by the amount of the Error (AGCE). If the Error is greater than the margin (9dB) but inside the dynamic range of the A/D (48dB - 9dB = 39dB), then adjust by the amount of the Error (AGCE) plus slightly more than the margin (9dB + 1dB = 10dB). If the Error falls below the dynamic range of the A/D, then coarsely-adjust by the amount of the dynamic range (48dB); if the Error is above the dynamic range, then adjust by slightly more than the margin (9dB + 1dB = 10dB). Finally, the current Error calculation and the previous gain setting (FAGCN) become the inputs to a digitally recursive infinite impulse response low pass filter (which is well understood by those ordinarily skilled in the art) to derive a new Filtered AGC Number (FAGCN). Thus, the signal is progressively gain-amplified (or gain-attenuated) until the signal falls within the dynamic range of the A/Ds and is further amplified (or attenuated) until optimum use (with appropriate margin) of the full (albeit limited) dynamic range of the A/Ds is obtained. The result of these various approximations for a plurality of TDM time slots may then be retained in memory (RAM) for resuming AGC control when the respective signals are expected to resume.

Furthermore, as these various gain calculation results are representative of the actually received signal strength (with appropriate compensation for overall loop gain characteristics), these gain determinations can be reported to the transmitting station for purposes of establishing transmission gain levels that optimally utilize the dynamic range of the receiver, thereby increasing spectral efficiency and frequency reuse in the system -- particularly cellular systems. Moreover, in a cellular-type system, the signal strength (gain determination) may be reported to the transmitting station by the receiver and hand off the transmission when the AGC adjustment crosses a certain threshold. Also, the signal strength (AGC level) of an adjacent cell (time slot) can be determined and evaluated to facilitate hand-off.

Figure 4 is a simplified diagram of an alternate embodiment of the invention. It illustrates an analog implementation of Automatic Gain Control that utilizes a power averaging circuit and comparator to implement the control process of Figure 3, described above. The power averaging circuit is well known by those ordinarily skilled in the relevant art and can readily be adapted to conform to the control process described above.

In summary then, there has been provided a method of digital Automatic Gain Control (AGC) in a receiver having limited dynamic range, particularly for discontinuous signals. The method comprises detecting the level of a received and AGC'd discontinuous signal, comparing the level of the AGC'd signal relative to the dynamic range of the receiver, and adjusting the AGC to establish a desired relationship between the AGC'd signal and the dynamic range limitation. There has also been provided a method of handoff in a TDMA cellular-type transmission system utilizing this method of AGC control.

The method for Automatic Gain Control (AGC) of discontinuous signals in a receiver having limited dynamic range has further been characterized by: digitizing a received and AGC'd discontinuous signal and converting the digitized samples to a power sample to sense the power of and detect the level of the signal, comparing the level of the AGC'd signal relative to the dynamic range of the receiver; and coarsely-adjusting by either progressively attenuating the signal until it falls within the dynamic range of the receiver or by progressively gain-amplifying the signal until it falls within the limited dynamic range of the receiver and finely-adjusting the AGC of the received signal until optimum use of the full (albeit limited) dynamic range of the signal processing stages is about 6-12 dB below maximum sensitivity to establish a desired relationship between the AGC'd signal and the dynamic range limitation.

While the preferred embodiment of the invention has been described and shown, it will be appreciated by those skilled in the art that other variations and modifications of this invention may be implemented. For example, this invention need not be limited to TDMA land-mobile systems, but is adaptable to AGC of digital and analog signals, including AM, FM or TV signals.

This discussion presupposed that the A/Ds provide the most severe constraint on the dynamic range of the receiver; however, this invention is equally applicable without regard to the particular stage providing the most severe constraint on the dynamic range of the receiver. Accordingly, all discussion has been framed in terms of the limited dynamic range of the receiver.

These and all other variations and adaptations are expected to fall within the ambit of the appended claims.

**Claims**

1. A Method of Automatic Gain Control (AGC) in a receiver having limited dynamic range characterized by:

   detecting the level of a received and AGC'd signal (Fig. 4: AVG PWR),

   comparing (Fig. 4: REF) the level of the AGC'd signal relative to the dynamic range of the receiver, and

   adjusting (FIG. 3) the AGC by either progressive attenuation or progressive amplification until the signal falls within the dynamic range of the receiver and further adjusting (FIG. 3) the AGC if the signal is within the dynamic range of the receiver to establish a desired relationship between the AGC'd signal and the dynamic range limitation.

**2.** A method as claimed in claim 1 above, wherein adjustment is characterized by coarsely adjusting the AGC until the signal falls within the dynamic range of the receiver and finely adjusting the AGC of the received signal if the signal is within the dynamic range of the receiver until optimum use of the full dynamic range of the receiver is obtained (Fig. 3).

**3.** A method as claimed in claim 2 above, wherein a margin of about 6-12 dB below the maximum capability of the receiver is maintained.

**4.** A method as claimed in any one of claims 1 to 3, wherein signal strength is reported to the transmitting station by the receiver for establishing transmission gain levels that optimally utilize the dynamic range of the receiver.

**5.** A method as claimed in any one of the preceding claims, wherein the signal is discontinuously separated into time slots in a TDMA system.

**6.** A method as claimed in claim 5 wherein the respective AGC levels of a plurality of time-discontinuous, but periodic, signals are established.

**7.** A method as claimed in claim 5 further characterized by: maintaining the last previous AGC level (RAM) for resuming AGC control when the signal is expected to resume.

**8.** A method as claimed in any one of the preceding claims wherein the signal strength of an adjacent cell is determined and evaluated to facilitate handoff determinations in a TDMA cellular-type system.

**9.** A method as claimed in any one of the preceding claims wherein signal strength is reported to the transmitting station by the receiver to facilitate hand-off determinations in a cellular-type system.

**10.** A method of handoff in a cellular type transmission system characterized by:
performing the method of any one of the preceding claims and
using the crossing of a threshold by the AGC adjustment in a decision to initiate handing off of the transmission.

**11.** A method as claimed in any one of the preceding claims, wherein detection is characterized by: sensing the power of the received and AGC'd signal (Fig. 4: AVG PWR).

**12.** A method as claimed in claim 11, wherein sensing is characterized by: digitizing (A/D) the signal and converting the digitized samples to a power sample.

**13.** A receiver having Automatic Gain Control (AGC) and having a component with a limited dynamic range, characterized by:
means for detecting the level of a received and AGC'd signal (Fig. 4: AVG PWR),
means for comparing (Fig. 4: REF) the level of the AGC'd signal relative to the dynamic range of the component, and
means for adjusting (FIG. 3) the AGC by either progressive attenuation or progressive amplification until the signal falls within the dynamic range of the receiver and further adjusting (FIG. 3) the AGC if the signal is within the dynamic range of the component to establish a desired relationship between the AGC'd signal and the dynamic range limitation.

**14.** A receiver according to claim 13 wherein the component is an analog-to-digital converter.

**Patentansprüche**

**1.** Verfahren zur automatischen Verstärkungsregelung (AGC) in einem Empfänger mit begrenztem Dynamikbereich, gekennzeichnet durch:
Ermitteln des Pegels eines empfangenen und automatisch verstärkungsgeregelten Signals (Fig. 4: AVGPWR),
Vergleichen (Fig. 4: REF) des Pegels des automatisch verstärkungsgeregelten Signals bezüglich des Dynamikbereichs des Empfängers, und
Justieren (Fig. 3) der AGC entweder durch progressive Abschwächung oder progressive Verstärkung, bis das Signal in den Dynamikbereich des Empfängers fällt, und weiteres Justieren (Fig. 3) der AGC, wenn das Signal im Dynamikbereich des Empfänger liegt, um eine gewünschte Beziehung zwischen dem automatisch verstärkungsgeregelten Signal und der Begrenzung des Dynamikbereichs herzustellen.

**2.** Verfahren nach Anspruch 1, bei dem die Justierung gekennzeichnet ist durch Grobjustieren der AGC, bis das Signal in den Dynamikbereich des Empfängers fällt, und Feinjustieren der AGC des empfangenen Signals, wenn das Signal im Dynamikbereich des Empfängers liegt, bis eine optimale Nutzung des vollen Dynamikbereichs des Empfängers erreicht wird (Fig. 3).

3. Verfahren nach Anspruch 2, bei dem ein Abstand von etwa 6-12 dB unter dem maximalen Vermögen des Empfängers bewahrt wird.

4. Verfahren nach einem der Ansprüche 1 bis 3, bei dem die Signalstärke durch den Empfänger der sendenden Station mitgeteilt wird, um Sendeverstärkungspegel festzulegen, die den Dynamikbereich des Empfängers optimal nutzen.

5. Verfahren nach einem der vorangehenden Ansprüche, bei dem das Signal in einem TDMA-System diskontinuierlich in Zeitkanäle getrennt wird.

6. Verfahren nach Anspruch 5, bei dem die jeweiligen AGC-Pegel einer Mehrzahl von Zeit-diskontinuierlichen aber periodischen Signalen festgelegt werden.

7. Verfahren nach Anspruch 5, weiter gekennzeichnet durch:
Bewahren des letzten vorangehenden AGC-Pegels (RAM), um die AGC-Regelung fortzusetzen, wenn erwartet wird, daß das Signal wieder einsetzt.

8. Verfahren nach einem der vorangehenden Ansprüche, bei dem die Signalstärke einer benachbarten Zelle ermittelt und bewertet wird, um Übergabeentscheidungen in einem zellularen TDMA-System zu erleichtern.

9. Verfahren nach einem der vorangehenden Ansprüche, bei dem die Signalstärke durch den Empfänger der Sendestation mitgeteilt wird, um Übergabeentscheidungen in einem zellularen System zu erleichtern.

10. Verfahren zur Übergabe in einem zellularen Übertragungssystem gekennzeichnet durch:
Durchführen des Verfahrens eines der vorangehenden Ansprüche und Verwenden des Kreuzens einer Schwelle durch die AGC-Justierung bei einer Entscheidung, um das Übergeben der Übertragung einzuleiten.

11. Verfahren nach einem der vorangehenden Ansprüche, bei dem die Ermittlung gekennzeichnet ist durch: Abtasten der Leistung des empfangenen und automatisch verstärkungsgeregelten Signals (Fig. 4: AVGPWR).

12. Verfahren nach Anspruch 11, bei dem das Abtasten gekennzeichnet ist durch: Digitalisieren (A/D) des Signals und Umwandeln der digitalisierten Momentwerte in einen Leistungsmomentwert.

13. Empfänger mit automatischer Verstärkungsregelung (AGC) und mit einem Glied mit begrenztem Dynamikbereich, gekennzeichnet durch:
eine Einrichtung zum Ermitteln des Pegels eines empfangenen und automatisch verstärkungsgeregelten Signals (Fig. 4: AVGPWR),
eine Einrichtung zum Vergleichen (Fig. 4: REF) des Pegels des automatisch verstärkungsgeregelten Signals bezüglich des Dynamikbereichs des Glieds, und
eine Einrichtung zum Justieren (Fig. 3) der AGC entweder durch progressive Abschwächung oder progressive Verstärkung, bis das Signal in den Dynamikbereich des Empfängers fällt, und weiteres Justieren (Fig. 3) der AGC, wenn das Signal im Dynamikbereich dieses Glieds liegt, um eine gewünschte Beziehung zwischen dem automatisch verstärkungsgeregelten Signal und der Begrenzung des Dynamikbereichs herzustellen.

14. Empfänger nach Anspruch 13, bei dem dieses Glied ein Analog/Digital-Wandler ist.

**Revendications**

1. Procédé de commande automatique de gain (CAG) dans un récepteur comportant une plage dynamique limitée, caractérisé par :
la détection du niveau d'un signal reçu et soumis à une CAG (figure 4 : AVG PWR),
comparaison (figure 4 : REF) du niveau du signal soumis à une CAG à la plage dynamique du récepteur ; et
réglage (figure 3) de la CAG au moyen de soit une atténuation progressive soit une amplification progressive jusqu'à ce que le signal tombe dans la plage dynamique du récepteur et réglage encore (figure 3) de la CAG si le signal s'inscrit dans la plage dynamique du récepteur afin d'établir une relation souhaitée entre le signal soumis à une CAG et la limitation de plage dynamique.

2. Procédé selon la revendication 1, dans lequel un réglage est caractérisé par un réglage grossier de la CAG jusqu'à ce que le signal tombe dans la plage dynamique du récepteur et par un réglage fin de la CAG du signal reçu si le signal s'inscrit dans la plage dynamique du récepteur jusqu'à ce qu'une utilisation optimum de la plage dynamique complète du récepteur soit obtenue (figure 3).

3. Procédé selon la revendication 2, dans lequel une marge d'environ 6 à 12 dB au-dessous de la capacité maximum du récepteur est maintenue.

4. Procédé selon l'une quelconque des revendications 1 à 3, dans lequel l'intensité de signal est rapportée à la station d'émission par le récepteur pour établir des niveaux de gain d'émission qui utilisent de façon optimum la plage dynamique du récepteur.

5. Procédé selon l'une quelconque des revendications précédentes, dans lequel le signal est séparé de façon discontinue en fenêtres temporelles dans un système AMRT.

6. Procédé selon la revendication 5, dans lequel les niveaux CAG respectifs d'une pluralité de signaux temporellement discontinus mais périodiques sont établis.

7. Procédé selon la revendication 5, caractérisé en outre par le maintien du dernier niveau CAG précédent (RAM) pour reprendre la commande CAG lorsqu'il est prévu que le signal doit reprendre.

8. Procédé selon l'une quelconque des revendications précédentes, dans lequel l'intensité de signal d'une cellule adjacente est déterminée et évaluée afin de faciliter des déterminations de transfert dans un système du type cellulaire AMRT.

9. Procédé selon l'une quelconque des revendications précédentes, dans lequel l'intensité de signal est rapportée à la station d'émission par le récepteur afin de faciliter des déterminations de transfert dans un système du type cellulaire.

10. Procédé de transfert dans un système d'émission du type cellulaire, caractérisé par :
la mise en oeuvre du procédé selon l'une quelconque des revendications précédentes ; et
l'utilisation du croisement d'un seuil par le réglage CAG lors d'une décision pour débuter un transfert de l'émission.

11. Procédé selon l'une quelconque des revendications précédentes, dans lequel une détection est caractérisée par la détection de la puissance du signal reçu et soumis à une CAG (figure 4 : AVG PWR).

12. Procédé selon la revendication 11, dans lequel la détection est caractérisée par une numérisation (A/N) du signal et par une conversion des échantillons numérisés en un échantillon de puissance.

13. Récepteur comportant une commande automatique de gain (CAG) et comportant un composant présentant une plage dynamique limitée, caractérisé par :
un moyen pour détecter le niveau haut d'un signal reçu et soumis à une CAG (figure 4 : AVG PWR) ;
un moyen pour comparer (figure 4 : REF) le niveau du signal soumis à une CAG à la plage dynamique du composant ; et
un moyen pour régler (figure 3) la CAG au moyen de soit une atténuation progressive soit une amplification progressive jusqu'à ce que le signal tombe dans la plage dynamique du récepteur et pour régler encore (figure 3) la CAG si le signal s'inscrit dans la plage dynamique du composant afin d'établir une relation souhaitée entre le signal soumis à une CAG et la limitation de plage dynamique.

14. Récepteur selon la revendication 13, dans lequel le composant est un convertisseur analogique/numérique.

*F I G. 1*

*F I G. 2*

*F I G. 4*

START TIME SLOT

INITIALIZE: PUT FAGCN IN D/A.
SETUP DMA TO TURN ON A/Ds, TAKE
N SAMPLES, AND STORE IN RAMs.
INTERRUPT WHEN COMPLETE.

CALCULATE THE AGC ERROR(AGCE)

IS
|AGCE|<9dB
?

→ YES →

RAW AGC NUMBER
(RAGCN)=FAGCN-AGCE

NO

IS
-9dB>AGCE>-39dB
?

→ YES →

RAW AGC NUMBER
(RAGCN)=FAGCN-AGCE-(-10dB)

NO

IS
AGCE<-39dB
?

→ YES →

RAW AGC NUMBER
(RAGCN)=FAGCN-(-48dB)

NO

AGCE>+9dB RAW AGC NUMBER
(RAGCN)=FAGCN-(10dB)

CALCULATE NEW
FILTERED AGC NUMBER (FAGCN)
USE RECURSIVE INSTANTANEOUS IMPULSE
RESPONSE LOW PASS FILTERING.

USE THE NEW VALUE DURING RECEPTION
OF THIS TIME SLOT DURING THE NEXT
FRAME, AND TO CALCULATE
RECEIVED SIGNAL STRENGTH.

*FIG.3*

CONTINUE (NEXT TIME SLOT)